# EUROPÄISCHE PATENTSCHRIFT

(11) **EP 1 719 189 B1**
(45) Veröffentlichungstag und Bekanntmachung des Hinweises auf die Patenterteilung: **03.04.2019**
(21) Anmeldenummer: 05706737.3
(22) Anmeldetag: 02.02.2005
(51) Int. Cl.: H01L 33/62, H01L 33/64, H01L 25/075, H05K 1/02, H05K 1/18

(54) **LEUCHTDIODEN-ANORDNUNG FÜR EINE HOCHLEISTUNGS-LEUCHTDIODE UND VERFAHREN ZUR HERSTELLUNG EINER LEUCHTDIODEN-ANORDNUNG**
LIGHT-EMITTING DIODE ARRANGEMENT FOR A HIGH-POWER LIGHT-EMITTING DIODE, AND METHOD FOR PRODUCING A LIGHT-EMITTING DIODE ARRANGEMENT
SYSTEME DE DIODES ELECTROLUMINESCENTES POUR DIODE ELECTROLUMINESCENTE DE GRANDE PUISSANCE ET PROCEDE DE PRODUCTION D'UN SYSTEME DE DIODES ELECTROLUMINESCENTES

(30) Priorität: 26.02.2004 DE 102004009284
(43) Veröffentlichungstag der Anmeldung: 08.11.2006
(73) Patentinhaber: OSRAM Opto Semiconductors GmbH, 93055 Regensburg (DE)
(72) Erfinder: FRIEDRICH, Marco, 93053 Regensburg (DE); KRAUS, Robert, 93051 Regensburg (DE)
(74) Vertreter: Epping - Hermann - Fischer
(86) Internationale Anmeldenummer: PCT/DE2005/000170
(87) Internationale Veröffentlichungsnummer: WO 2005/083803

(56) Entgegenhaltungen:
- DE-A1- 10 134 381
- DE-A1- 10 246 892
- DE-A1- 19 922 176
- DE-A1- 19 926 746
- DE-T2- 69 222 623
- DE-U1- 20 120 770
- US-A1- 2002 001 193
- US-B1- 6 520 669

## Beschreibung

Die Erfindung betrifft eine Leuchtdioden-Anordnung für Hochleistungs-Leuchtdioden, die auf eine flexible Leiterplatte montiert sind. Ferner betrifft die Erfindung ein Verfahren zur Herstellung solcher Leuchtdioden-Anordnung.

Die Druckschrift DE 199 22 176 A1 beschreibt ein auf einem Flexboard oberflächenmontiertes Leuchtdiodenarray, das auf einem Kühlkörper aufgebracht ist. Der Kühlkörper kann dabei jede gewünschte Form aufweisen, so dass Kraftfahrzeugleuchten wie Blinker oder dergleichen konstruiert werden können, die der Außenkontur des Fahrzeugs angepasst werden können.

Die Druckschrift US 6,520,669 B beschreibt eine Lichtquelle für einen Kfz-Scheinwerfer, wobei Leuchtdioden der Lichtquelle auf einer Leiterplatte mit elektrischen Leiterbahnen angeordnet sind. In der Druckschrift DE 199 26 746 A ist eine Anordnung mit einer Mehrzahl von zusammenhängenden Leiterplatten beschrieben, auf denen LEDs montiert sind, wobei die Leiterplatten durch Verbindungsglieder untereinander verbunden sind. Die Druckschrift DE 201 20 770 U betrifft eine oberflächenmontierte LED-Anordnung mit einer flexiblen Leiterplatte und einer Vielzahl von LEDs, wobei die LEDs auf einer Hauptfläche der flexiblen Leiterplatte angeordnet sind und wobei ein Kühlkörper mit der den LEDs abgewandten Hauptfläche der flexiblen Leiterplatte verbunden ist.

Die Druckschrift DE 102 46 892 A1 beschreibt eine Leuchtdiodenmatrix mit einem Metallsubstrat, einer auf dem Metallsubstrate angeordnete dielektrische Schicht und einer Mehrzahl von Leiterbahnschichten sowie thermischen Kontakten. Die Druckschrift DE 692 22 623 T2 beschreibt einen Lichtquellenabschnitt mit zumindest einen Leuchtdiodenchip, der auf einem Elektrodenschaltungselement einer flexiblen gedruckten Schaltungsplatine angeordnet ist.

Es ist Aufgabe der vorliegenden Erfindung, eine Leuchtdioden-Anordnung für Hochleistungs-Leuchtdioden anzugeben, die besonders leicht zu montieren ist. Ferner ist es Aufgabe der Erfindung, ein Verfahren zur Herstellung solch einer Leuchtdioden-Anordnung anzugeben.

Die Aufgaben werden gelöst durch die Leuchtdioden-Anordnung nach Patentanspruch 1 und ferner durch ein Verfahren zu deren Herstellung nach Patentanspruch 33. Vorteilhafte Ausgestaltungen der Erfindung sind Gegenstand von Unteransprüchen.

Es wird eine Leuchtdioden-Anordnung angegeben, die wenigstens eine Hochleistungs-Leuchtdiode aufweist. Die Hochleistungs-Leuchtdiode ist dabei auf eine flexible Leiterplatte montiert. Unter Hochleistungs-Leuchtdioden versteht man in diesem Zusammenhang sogenannte High Power Leuchtdioden, die eine Leistungsaufnahme von wenigstens 300 mW haben. Die typische Leistungsaufnahme für eine Hochleistungs-Leuchtdiode liegt zwischen 1 und 3 W. Ein Beispiel für solch eine Hochleistungs-Leuchtdiode stellt beispielsweise die aus der Druckschrift DE 101 17 889 A1 bekannte Leuchtdiode dar.

Aufgrund ihrer relativ hohen Leistungsaufnahme weisen Hochleistungs-Leuchtdioden eine starke Wärmeabstrahlung auf. Die genannte Dragon-Leuchtdiode besitzt daher ein thermisches Anschlussteil, das auf einem Montageträger aufliegt und durch das die beim Betrieb der LED entstehende Wärme an den Montageträger abgegeben wird.

Bei der vorliegenden Leuchtdioden-Anordnung ist der Montageträger durch eine flexible Leiterplatte gegeben. In einer bevorzugten Ausführungsform der Leuchtdioden-Anordnung wird die Hochleistungs-Leuchtdiode auf die flexible Leiterplatte gelötet. Durch den Lötprozess wird die Leuchtdiode sowohl elektrisch mit der flexiblen Leiterplatte kontaktiert, als auch mechanisch auf der Leiterplatte fixiert.

Die flexible Leiterplatte enthält wenigstens eine flexible Trägerschicht. Dabei enthält die flexible Trägerschicht bevorzugt eines der folgenden Materialien: Polyimid, Polyethylennaphtalat, Polyester, FR4. Auch andere Materialien können für eine Verwendung in der flexiblen Trägerschicht der Leiterplatte geeignet sein, wenn dabei die Flexibilität der Leiterplatte erhalten bleibt und eine gute Weiterleitung der von der Hochleistungs-Leuchtdiode erzeugten Wärme durch die Trägerschicht gewährleistet ist.

Weiter enthält die flexible Leiterplatte eine wärmeleitende Schicht. Diese wärmeleitende Schicht befindet sich in thermischem Kontakt mit der Hochleistungs-Leuchtdiode.

Dieser thermische Kontakt kann beispielsweise dadurch hergestellt sein, dass das thermische Anschlussteil der Hochleistungs-Leuchtdiode auf die wärmeleitenden Schicht gelötet ist. Von dem thermischen Anschlussteil der Hochleistungs-Leuchtdiode breitet sich die Wärme zunächst in der wärmeleitenden Schicht aus. Anschließend wird die Wärme großflächig an die Umgebung abgegeben und beispielsweise von der flexiblen Trägerschicht aufgenommen. Ihrerseits leitet die flexible Trägerschicht die Wärme großflächig an die Umgebung ab.

Wegen der guten Wärmeleiteigenschaften von Metall wird für die wärmeleitende Schicht bevorzugt ein Metall verwendet. In einer besonders bevorzugten Ausführungsform der Leuchtdioden-Anordnung enthält die wärmeleitende Schicht Kupfer.

In einer erfindungsgemäßen Ausführungsform der Leuchtdioden-Anordnung befinden sich die wärmeleitende Schicht sowie die elektrischen Leiterbahnen in derselben Ebene der flexiblen Leiterplatte. Die wärmeleitende Schicht ist eine separate Schicht. Das heißt, wärmeleitende Schicht und elektrische Leiterbahnen befinden sich in einer gemeinsamen Ebene der flexiblen Leiterplatte, sind aber nicht miteinander verbunden. Erfindungsgemäß steht die wärmleitende Schicht nicht in elektrischem Kontakt mit den Leiterbahnen. Beispielsweise steht die wärmleitende Schicht in thermischem Kontakt mit einem oben beschriebenen thermischem Anschlussteil der Leuchtdiode.

In einer bevorzugten Ausführungsform der Leuchtdioden-Anordnung enthalten die wärmeleitende Schicht sowie die elektrischen Leiterbahnen das gleiche Metall. Wegen seiner guten thermischen und elektrischen Leitfähigkeit ist beispielsweise Kupfer für den Einsatz in der wärmeleitenden Schicht und den elektrischen Leiterbahnen gleichermaßen gut geeignet.

In einer Ausführungsform der Leuchtdioden-Anordnung, ist eine der Oberflächen der flexiblen Leiterplatte mit einer elektrisch isolierenden Schicht bedeckt. Bevorzugt enthält die isolierende Schicht Lötstopplack. In einer besonders bevorzugten Ausführungsform weist die isolierende Schicht Ausnehmungen zur thermischen und elektrischen Kontaktierung der Hochleistungs-Leuchtdiode auf. Durch diese Ausnehmungen hindurch kann die Hochleistungs-Leuchtdiode beispielsweise thermisch an die wärmeleitende Schicht und elektrisch an die Leiterbahnen angeschlossen werden.

In einer besonders bevorzugten Ausführungsform der Leuchtdioden-Anordnung wird auf die, den Hochleistungs-Leuchtdioden abgewandte Seite der flexiblen Leiterplatte eine klebemittelhaltige Schicht aufgebracht. Diese klebemittelhaltige Schicht wird dabei bevorzugt durch ein doppelseitiges Klebeband gebildet, das mit einer seiner klebenden Oberflächen so auf die flexible Leiterplatte aufgeklebt wird, dass es die Leiterplatte vollständig bedeckt und an den Rändern bündig mit dieser abschließt.

Um ein unbeabsichtigtes Aufkleben der Leiterplatte zu verhindern, ist das auf der Leiterplatte befestigte Klebeband vorzugsweise mit einer Schutzfolie an seiner freien Oberfläche versiegelt. Vor einem Aufbringen der Leuchtdioden-Anordnung an ihrem Bestimmungsort muss diese Schutzfolie lediglich abgezogen werden. Mit anderen Worten kann die Leuchtdiodenanordnung im Sinne eines Abziehbilds auf ihren Bestimmungsort aufgeklebt werden.

In einer besonders bevorzugten Ausführungsform der Leuchtdioden-Anordnung enthält die Schutzfolie dabei einen Kunststoff.

Bevorzugt wird für die Leuchtdioden-Anordnung eine besonders hitzebeständige klebemittelhaltige Schicht verwendet. Die klebemittelhaltige Schicht kann dabei kurzzeitig Temperaturen bis zu 250° C unbeschädigt überstehen. Bei kurzzeitigem Erhitzen der klebemittelhaltigen Schicht auf diesen Temperaturwert verliert die klebemittelhaltige Schicht ihre haftende Wirkung nicht. Ein festes Haften der Leuchtdioden-Anordnung an ihren Bestimmungsort bleibt also auch bei Erhitzen der klebemittelhaltigen Schicht gewährleistet.

Besonders bevorzugt ist hierbei eine besonders dünne klebemittelhaltige Schicht, die maximal 60 µm dick ist. Dadurch ist zum einen gewährleistet, dass die Leuchtdioden-Anordnung insgesamt sehr dünn ist, zum anderen wird die von der Hochleistungs-Leuchtdiode an die flexible Leiterplatte abgegebene Wärme durch eine solch dünne Schicht besonders gut geleitet und kann von dort dann an die Umgebung, beispielsweise die Fläche, auf welche die Leuchtdioden-Anordnung geklebt ist, abgegeben werden.

In einer besonders bevorzugten Ausführungsform der Leuchtdioden-Anordnung ist eine Vielzahl von Hochleitungs-Leuchtdioden auf der flexiblen Leiterplatte aufgebracht. Dabei werden die Hochleistungs-Leuchtdioden bevorzugt in Reihe geschaltet.

Zu jeder Hochleistungs-Leuchtdiode ist bevorzugt ein Paar von Kontaktflächen vorgegeben, über das die Hochleistungs-Leuchtdiode elektrisch kontaktiert werden kann.

Die Leuchtdioden-Anordnung ist bevorzugt in Abschnitte unterteilt, wobei jeder Abschnitt eine Hochleistungs-Leuchtdiode und das zugehörige Paar von Kontaktflächen aufweist. Vorteilhaft werden diese Abschnitte auf der Leiterplatte als sich wiederholende, regelmäßige Strukturen angeordnet.

In einer besonders bevorzugten Ausführungsform der Leuchtdioden-Anordnung sind diese Abschnitte in einer Reihe angeordnet. Mit der beschriebenen Anordnung ist es möglich, die Gesamtheit der Hochleitungs-Leuchtdioden auf der flexiblen Leiterplatte dadurch zu kontaktieren, dass die beiden äußersten Kontaktflächen- an entgegengesetzten Seite der Leuchtdioden-Anordnung- auf der Leiterplatte an eine Stromquelle angeschlossen werden.

Weiter ermöglicht der beschriebene Aufbau der Leuchtdioden-Anordnung ein besonders einfaches Zerteilen der Leuchtdioden-Anordnung zwischen den Abschnitten, so dass Teil-Leuchtdioden-Anordnungen mit jeweils einer geringeren Zahl von Abschnitten als die ursprüngliche Leuchtdioden-Anordnung entstehen. Auch bei diesen Leuchtdioden-Anordnungen, mit einer geringeren Zahl von Hochleistungs-Leuchtdioden, ist es möglich, in der beschriebenen Weise jeweils die Gesamtheit der Leuchtdioden auf der Anordnung zu kontaktieren. Ein Zerteilen der Leuchtdioden-Anordnung ist dabei so weit möglich, dass einzelne Abschnitte mit jeweils einer Hochleistungs-Leuchtdiode und einem Paar von Kontaktflächen entstehen. Die Größe der Leuchtdioden-Anordnung und die Zahl der Leuchtdioden kann auf diese Weise ihrem Bestimmungszweck und den Gegebenheiten des Bestimmungsortes angepasst werden. Das heißt die Leuchtdioden-Anordnung wird beispielsweise an die benötigte Leuchtkraft oder den vorhandenen Platz angepasst.

Weiter wird eine Beleuchtungseinrichtung, bei der die Leuchtdioden-Anordnung auf einen vorgegebenen Kühlkörper aufgebracht ist, angegeben. Vorzugsweise wird die Leuchtdioden-Anordnung dabei mit ihrer klebstoffhaltigen Schicht auf den Kühlkörper aufgeklebt. Durch das Aufkleben der Leuchtdioden-Anordnung ist dabei zugleich eine mechanische Befestigung der Anordnung auf dem Kühlkörper, als auch eine thermische Ankopplung der Anordnung an den Kühlkörper gewährleistet. So wird die von den Hochleistungs-Leuchtdioden abgestrahlte Wärme beispielsweise zunächst an die wärmeleitende Schicht abgeführt. Von dort wird die Wärme großflächig an die flexible Schicht abgegeben. Durch die dünne klebemittelhaltige Schicht hindurch wird die Wärme dann an den Kühlkörper abgegeben.

Wegen seiner besonders guten Wärmeleitfähigkeit enthält der Kühlkörper vorzugsweise ein Metall. In einer Ausführungsform der Beleuchtungseinrichtung ist der Kühlkörper Teil eines Leuchtengehäuses. In einer besonders bevorzugten Ausführungsform handelt es sich bei dem Leuchtengehäuse um ein Gehäuse für eine Autoinnenbeleuchtung, eine Autorückbeleuchtung, eine Bremsleuchte, einen Blinker, oder dergleichen. Die Leuchtdioden-Anordnung passt sich aufgrund der flexiblen Leiterplatte an die Form des jeweiligen Leuchtengehäuses an.

Ferner wird ein Verfahren zur Herstellung einer Leuchtdioden-Anordnung angegeben. Dabei wird zunächst eine klebemittelhaltige Schicht auf die flexible Leiterplatte aufgebracht. Anschließend werden die Leuchtdioden auf die der klebemittelhaltigen Schicht abgewandte Seite der Leiterplatte gelötet. Dabei kann das Aufbringen der klebemittelhaltigen Schicht vor dem Lötvorgang erfolgen, da ein besonders hitzebeständiges Klebemittel Verwendung findet. Diese Reihenfolge des Herstellungsprozesses erweist sich auch deshalb als besonders vorteilhaft, da ein Aufbringen der klebemittelhaltigen Schicht auf die flexible Leiterplatte ohne vormontierte Leuchtdioden besonders einfach erfolgen kann.

Im folgenden wird die hier beschriebene Leuchtdioden-Anordnung anhand eines Ausführungsbeispiels und den dazugehörigen Figuren näher erläutert.
Figur 1 zeigt eine schematische Darstellung der Oberfläche der flexiblen Leiterplatte der Leuchtdioden-Anordnung.
Figur 2 zeigt eine schematische Darstellung der Ebene der wärmeleitenden Schicht und der elektrischen Leiterbahnen.
Figur 3 zeigt eine Schnittansicht durch einen Abschnitt der Leuchtdioden-Anordnung.

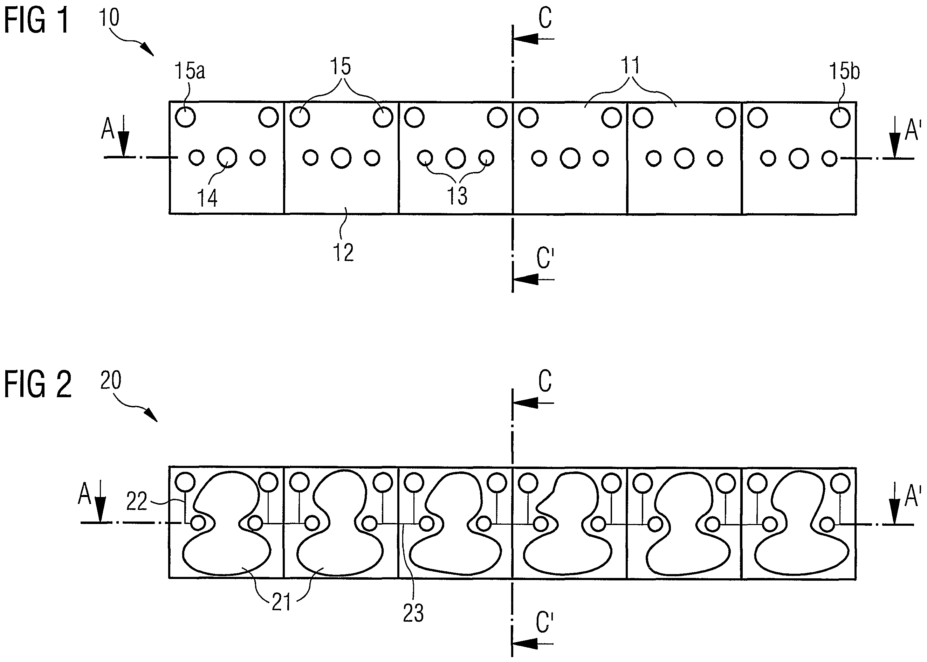

Figur 1 zeigt die Oberfläche der flexiblen Leiterplatte 10 der Leuchtdioden-Anordnung unterteilt in sechs Abschnitte 11. Figur 1 zeigt dabei die Oberseite der Leiterplatte 10, auf welche die Leuchtdioden 34 aufgebracht werden können. Die Oberfläche der flexiblen Leiterplatte 10 ist mit einer Isolierschicht 12 bedeckt. In der Isolierschicht 12 befinden sich Ausnehmungen durch die hindurch ein Anschluss an die elektrischen Anschlussstellen 13, die thermische Kontaktfläche 14 und die elektrischen Kontaktflächen 15 möglich ist.

Das Ausführungsbeispiel einer Leuchtdioden-Anordnung mit sechs Abschnitten 11 ist dabei nicht einschränkend. Vielmehr ist es möglich Leuchtdioden-Anordnungen 10 mit einer beliebigen Anzahl von Abschnitten 11 herzustellen.

Die flexible Leiterplatte 11 weist an ihrer Oberfläche eine Isolierschicht 12 auf. Die Isolierschicht 12 ist durch eine Schicht gegeben, die Lötstopplack enthält.

Die elektrischen Anschlussstellen 13 befinden sich unter Ausnehmungen der Isolierschicht 12. An den elektrischen Anschlussstellen 13 wird eine Hochleistungs-Leuchtdiode mit der flexiblen Leiterplatte elektrisch kontaktiert und mechanisch befestigt. Elektrische Kontaktierung und mechanische Fixierung der Hochleistungs-Leuchtdiode finden dabei bevorzugt mittels einer Lötverbindung statt.

Die thermische Kontaktfläche 14 befindet sich unter einer Ausnehmung der Isolierschicht 12. An der thermischen Kontaktfläche 14 erfolgt eine thermische Ankopplung der Hochleistungs-Leuchtdiode an die wärmeleitende Schicht. Bevorzugt werden das thermische Anschlussteil der Hochleistungs-Leuchtdiode und die wärmeleitende Schicht an der thermischen Kontaktfläche 14 mittels einer Lötverbindung kontaktiert, so dass neben der thermischen Kontaktierung eine zusätzliche mechanische Befestigung der Hochleistungs-Leuchtdiode an die flexible Leiterplatte erfolgt. Alternativ zur Lötverbindung kann aber auch ein thermisch leitender, temperaturstabiler Klebstoff Verwendung finden.

Über die elektrischen Kontaktflächen 15 wird die Hochleistungs-Leuchtdiode elektrische kontaktiert. Dabei kann die Gesamtheit aller Leuchtdioden der Leuchtdioden-Anordnung kontaktiert werden, indem die beiden äußersten elektrischen Kontaktflächen 15a und 15b an eine Stromquelle angeschlossen werden.

Die Figur 2 zeigt die Ebene der Leiterplatte 10 mit der wärmeleitenden Schicht 21 und den elektrischen Leiterbahnen 22, 23 der flexiblen Leiterplatte 10.

Über die thermische Kontaktfläche 14 wird die Hochleistungs-Leuchtdiode an die wärmeleitende Schicht 21 angekoppelt. Die wärmeleitende Schicht 21 weist dabei eine besonders große Fläche auf, damit die von der Hochleistungs-Leuchtdiode abgegebene Wärme großflächig an die Umgebung abgegeben werden kann. Die wärmeleitende Schicht 21 steht dabei nicht in elektrischem Kontakt zu elektrischen Leiterbahnen 22, Kontaktflächen 15 oder Anschlussstellen 13.

Beispielsweise kann die wärmeleitende Schicht 21 eine im wesentlichen runde Form aufweisen. Beispielsweise nimmt die wärmeleitende Schicht 21 wenigstens 60 Prozent der Fläche der Ebene der Leiterplatte 10 ein, in der sie sich befindet. Bevorzugt nimmt sie wenigsten 70 Prozent, besonders bevorzugt wenigsten 80 Prozent ein.

Die elektrischen Kontaktflächen 15 und die elektrische Anschlussstellen 13 sind durch erste elektrische Leiterbahnen 22 miteinander verbunden. Die elektrische Anschlussstellen 13 sind untereinander durch zweite elektrischen Leiterbahnen 23 miteinander verbunden. Die wärmeleitende Schicht 21 sowie die elektrischen Leiterbahnen 22 und 23 können dabei das gleiche Metall enthalten. Bevorzugt findet dabei wegen seiner guten elektrischen und thermischen Leitfähigkeit Kupfer Verwendung.

Der gezeigte Aufbau der Leuchtdioden-Anordnung ermöglicht es dabei, die Leuchtdioden-Anordnung beispielsweise entlang der Line C-C' zu durchtrennen, ohne dass die Kontaktierungsmöglichkeiten eingeschränkt werden. Dadurch entstehen in diesem Beispiel zwei Leiterplatten 10, die jeweils drei Hochleistungs-Leuchtdioden umfassen.

Ein elektrischer Anschluss dieser Hochleistungs-Leuchtdioden kann wiederum über eine Kontaktierung der beiden äußersten Kontaktflächen an einer Stromquelle erfolgen. Natürlich ist es möglich die Leuchtdiode auch zwischen den anderen Abschnitten 11 der Leuchtdioden-Anordnung zu durchtrennen. Es ist dabei möglich die Leuchtdioden-Anordnung soweit zu zertrennen, dass Leuchtdioden-Anordnungen entstehen, die jeweils nur mehr einen Abschnitt 11 mit einer einzigen Hochleistungs-Leuchtdiode aufweisen.

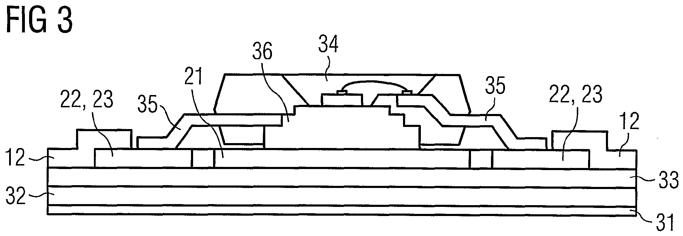

Figur 3 zeigt eine Schnittansicht durch einen Abschnitt 11 der Leuchtdioden-Anordnung entlang der Schnittlinie A-A'. Die Leuchtdioden-Anordnung besteht dabei aus einer flexiblen Leiterplatte, auf die eine Hochleistungs-Leuchtdiode 34 mit ihren elektrischen Anschlussteilen 35 und ihrem thermischen Anschlussteil 36 montiert ist. Die flexible Leiterplatte umfasst in diesem Ausführungsbeispiel die folgenden Schichten: eine Schutzfolie 31, eine klebemittelhaltige Schicht 32, eine Trägerschicht 33, die wärmeleitende Schicht 21 und die elektrischen Leiterbahnen 22,23, sowie eine Isolierschicht 12.

An der Unterseite der Leuchtdioden-Anordnung 10 befindet sich die Schutzfolie 31, die einen Kunststoff enthält. Die Schutzfolie bedeckt die klebemittelhaltige Schicht 32. Dabei schützt die Schutzfolie 31 die klebemittelhaltige Schicht 32 einerseits vor einer Verschmutzung, anderseits verhindert sie ein unbeabsichtigtes Aufkleben der Leuchtdioden-Anordnung. Die Schutzfolie 31 ist dabei so gestaltet, dass sie sich leicht, in einem Arbeitsschritt von der klebemittelhaltigen Schicht 32 abziehen lässt.

Die klebemittelhaltige Schicht 32 ist im vorliegenden Ausführungsbeispiel durch ein doppelseitiges Klebeband gegeben. Dieses Klebeband ist zum einen sehr hitzebeständig gewählt, so dass es Temperaturen von bis zu 250 °C unbeschädigt überstehen kann. Zum anderen wird ein sehr dünnes Klebeband gewählt. Im vorliegenden Ausführungsbeispiel ist die klebemittelhaltige Schicht 32 lediglich 50 µm dick. Dadurch ist gewährleistet, dass die von der Hochleistungs-Leuchtdiode 34 abgegebene Wärme durch die klebemittelhaltige Schicht besonders schnell an die Umgebung abgegeben werden kann.

Die klebemittelhaltige Schicht 32 ist an der flexiblen Trägerschicht 33 befestigt. Die Trägerschicht 33 enthält dabei vorzugsweise eines der folgenden Materialien: Polyimid, Polyethylennaphtalat, Polyester oder FR4. Dabei ist denkbar, dass auch andere Kunststoffe für einen Einsatz in der Trägerschicht 33 in Betracht kommen. Wichtig ist dabei, dass die Flexibilität der Leuchtdioden-Anordnung erhalten bleibt und die Trägerschicht 33 die beim Betrieb der Hochleistungs-Leuchtdiode entstehende Wärme gut ableitet.

Auf die Trägerschicht 33 sind die wärmeleitende Schicht 21 und die elektrischen Leiterbahnen 22,23 aufgebracht. Ihnen folgt die Isolierschicht 12.

Die Hochleistungs-Leuchtdiode 34 ist an den elektrische Anschlussstellen 13 mit ihren elektrischen Anschlussteilen 35 aufgebracht und somit mit elektrischen Leiterbahnen 22,23 verbunden. Das thermische Anschlussteil 36 der Hochleistungs-Leuchtdiode 34 liegt dabei auf der thermischen Kontaktfläche 14 auf und ist an ihr auf die wärmeleitende Schicht 21 gelötet.

Die Erfindung ist nicht durch die Beschreibung anhand der Ausführungsbeispiele sondern nur durch den Gegenstand der Ansprüche beschränkt.

## Patentansprüche

1. Leuchtdioden-Anordnung, mit wenigstens einer Hochleistungs-Leuchtdiode (34) und einer flexiblen Leiterplatte (10) mit elektrischen Leiterbahnen (22, 23), wobei die Hochleistungs-Leuchtdiode (34) auf die flexible Leiterplatte (10) montiert ist, wobei
- die flexible Leiterplatte (10) eine wärmeleitende Schicht (21) enthält, die im thermischen Kontakt mit der Hochleistungs-Leuchtdiode (34) steht, und
- sich die wärmeleitende Schicht (21) und die elektrischen Leiterbahnen (22, 23) in einer gemeinsamen Ebene der flexiblen Leiterplatte (10) befinden, die flexible Leiterplatte (10) eine flexible Trägerschicht (33) enthält, wobei die elektrischen Leiterbahnen (22, 23) auf die flexible Trägerschicht (33) aufgebracht sind,
**dadurch gekennzeichnet, dass** die wärmeleitende Schicht (21) auf die flexible Trägerschicht aufgebracht ist, und die wärmeleitende Schicht (21) nicht in elektrischem Kontakt mit den elektrischen Leiterbahnen (22, 23) steht.

2. Leuchtdioden-Anordnung nach Anspruch 1,
bei der die wärmeleitende Schicht (21) und die elektrischen Leiterbahnen (22, 23) auf der gemeinsamen Ebene der flexiblen Leiterplatte (10) nicht miteinander verbunden sind und die Hochleistungs-Leuchtdiode (34) auf der wärmeleitenden Schicht gelötet ist.

3. Leuchtdioden-Anordnung nach einem der vorhergehenden Ansprüche,
bei der die wärmeleitende Schicht (21) wenigstens 60 Prozent einer Fläche der gemeinsamen Ebene der Leiterplatte (10) einnimmt.

4. Leuchtdioden-Anordnung nach einem der vorhergehenden Ansprüche,
bei der die Hochleistungs-Leuchtdiode (34) eine Leistungsaufnahme von wenigstens 300 mW hat.

5. Leuchtdioden-Anordnung nach einem der vorhergehenden Ansprüche,
bei der die Hochleistungs-Leuchtdiode (34) ein thermisches Anschlussteil (36) aufweist, das im thermischen Kontakt mit der wärmeleitenden Schicht (21) steht.

6. Leuchtdioden-Anordnung nach einem der vorhergehenden Ansprüche,
bei der die Hochleistungs-Leuchtdiode (34) auf die flexible Leiterplatte (10) gelötet ist.

7. Leuchtdioden-Anordnung nach dem Anspruch 5
bei der die flexible Leiterplatte (10) ein Montageträger ist und bei der die beim Betrieb der Hochleistungs-Leuchtdiode entstehende Wärme an den Montageträger abgegeben wird.

8. Leuchtdioden-Anordnung nach einem der vorhergehenden Ansprüche,
bei der die flexible Trägerschicht (33) wenigstens eines der folgenden Materialien enthält: Polyimid, Polyethylennaphtalat, Polyester, FR4.

9. Leuchtdioden-Anordnung nach einem der vorhergehenden Ansprüche,
bei der die wärmeleitende Schicht (21) ein Metall enthält.

10. Leuchtdioden-Anordnung nach einem der vorhergehenden Ansprüche,
bei der die wärmeleitende Schicht (21) Kupfer enthält.

11. Leuchtdioden-Anordnung nach einem der vorhergehenden Ansprüche,
bei der die Hochleistungs-Leuchtdiode (34) auf die wärmeleitende Schicht (21) gelötet ist.

12. Leuchtdioden-Anordnung nach einem der vorhergehenden Ansprüche,
bei der die wärmeleitende Schicht (21) und die elektrischen Leiterbahnen (22), (23) das gleiche Metall enthalten.

13. Leuchtdioden-Anordnung einem der vorhergehenden Ansprüche,
bei der auf eine der Oberflächen der flexiblen Leiterplatte (10) eine Isolierschicht (12) aufgebracht ist.

14. Leuchtdioden-Anordnung nach dem vorhergehenden Anspruch, bei der die Isolierschicht (12) Ausnehmungen für die elektrische und thermische Kontaktierung der Hochleistungs-Leuchtdiode (34) aufweist.

15. Leuchtdioden-Anordnung nach den Ansprüchen 13 und 14, bei der die Isolierschicht (12) einen Lötstopplack enthält.

16. Leuchtdioden-Anordnung nach einem der vorhergehenden Ansprüche, bei der die den Hochleistungs-Leuchtdioden (34) abgewandte Seite der flexiblen Leiterplatte (10) eine klebemittelhaltige Schicht (32) aufweist.

17. Leuchtdioden-Anordnung nach dem vorhergehenden Anspruch, bei der die klebemittelhaltige Schicht (32) durch ein doppelseitiges Klebeband gebildet ist.

18. Leuchtdioden-Anordnung nach einem der Ansprüche 16 bis 17,
bei der die klebemittelhaltige Schicht (32) bis zu Temperaturen von 250°C hitzebeständig ist.

19. Leuchtdioden-Anordnung nach den Ansprüchen 16 bis 18, bei der die klebemittelhaltige Schicht (32) maximal 60 µm dick ist.

20. Leuchtdioden-Anordnung nach den Ansprüchen 16 bis 19, bei der die klebemittelhaltige Schicht (32) mit einer Schutzfolie (31) bedeckt ist.

21. Leuchtdioden-Anordnung nach dem vorhergehenden Anspruch, bei der die Schutzfolie (31) einen Kunststoff enthält.

22. Leuchtdioden-Anordnung nach einem der vorhergehenden Ansprüche,
bei der eine Vielzahl von Hochleistungs-Leuchtdioden (34) vorgesehen sind, die in Reihe geschaltet sind.

23. Leuchtdioden-Anordnung nach Anspruch 22,
bei der zu jeder Hochleistungs-Leuchtdiode (34) ein Paar von Kontaktflächen (15) vorgesehen ist.

24. Leuchtdioden-Anordnung nach dem vorhergehenden Anspruch, die in Abschnitte (11) unterteilt ist, wobei die Abschnitte jeweils eine Hochleistungs-Leuchtdiode (34) und ein der Hochleistungs-Leuchtdiode zugehöriges Paar von Kontaktflächen (15) aufweisen.

25. Leuchtdioden-Anordnung nach einem der vorhergehenden Ansprüche 22 bis 24,
bei der die Hochleistungs-Leuchtdioden (34) jeweils im thermischen Kontakt mit einer wärmeleitenden Schicht (21) stehen und die Leuchtdioden-Anordnung so zerteilbar ist, dass einzelne Abschnitte (11) mit jeweils einer Hochleistungs-Leuchtdiode (34), einer wärmeleitenden Schicht (21) und dem Paar von Kontaktflächen (15) entstehen.

26. Leuchtdioden-Anordnung nach einem der Ansprüche 24 bis 25,
bei der die Abschnitte (11) als sich wiederholende Strukturen angeordnet sind.

27. Leuchtdioden-Anordnung nach dem vorhergehenden Anspruch, bei der die Abschnitte (11) in einer Reihe angeordnet sind.

28. Beleuchtungseinrichtung,
aufweisend eine Leuchtdioden-Anordnung nach einem der vorangehenden Ansprüche, wobei ein Kühlkörper vorgegeben ist, auf dem die Leuchtdioden-Anordnung aufgebracht ist.

29. Beleuchtungseinrichtung nach dem vorhergehenden Anspruch,
bei der die Leuchtdioden-Anordnung auf den Kühlkörper geklebt ist.

30. Beleuchtungseinrichtung nach einem der Ansprüche 28 bis 29,
bei der der Kühlkörper ein Metall enthält.

31. Beleuchtungseinrichtung nach einem der Ansprüche 28 bis 30,
bei der der Kühlkörper Teil eines Leuchtengehäuses ist.

32. Beleuchtungseinrichtung nach dem vorhergehenden Anspruch,
bei der das Leuchtengehäuse das Gehäuse für eine der folgenden Leuchten ist: Autoinnenbeleuchtung, Autorückbeleuchtung, Bremsleuchte, Blinker.

33. Verfahren zur Herstellung einer Leuchtdioden-Anordnung nach Anspruch 1,
wobei eine klebemittelhaltige Schicht (32) an der flexiblen Trägerschicht (33) befestigt wird, auf die der klebemittelhaltigen Schicht (32) abgesandten Seite der flexiblen Trägerschicht(33) die wärmeleitende Schicht (21) und die elektrischen Leiterbahnen (22,23) aufgebracht werden, eine Vielzahl von Hochleistungs-Leuchtdioden (34) auf die elektrischen Leiterbahnen (22,23) gelötet wird, und
das Aufbringen der klebemittelhaltigen Schicht vor dem Löten der Hochleistungs-Leuchtdioden erfolgt.

## Claims

1. A light emitting diode arrangement having at least one high-power light emitting diode (34) and a flexible circuit board (10) with electrical conductor tracks (22, 23), wherein the high-power light emitting diode (34) is mounted on the flexible circuit board (10), wherein
- the flexible circuit board (10) includes a thermally conductive layer (21) which is in thermal contact with the high-power light emitting diode (34); and
- the thermally conductive layer (21) and the electrical conductor tracks (22, 23) are located in a common plane of the flexible circuit board (10), the flexible circuit board (10) contains a flexible carrier layer (33), wherein the electrical conductor tracks (22, 23) are applied to the flexible carrier layer (33),
**characterized in that**
the thermally conductive layer (21) is applied to the flexible carrier layer, and the thermally conductive layer (21) is not in electrical contact with the electrical conductor tracks (22, 23).

2. The light emitting diode arrangement according to claim 1,
in which the thermally conductive layer (21) and the electrical conductor tracks (22, 23) are not connected to one another on the common plane of the flexible circuit board (10) and the high-power light emitting diode (34) is soldered on the thermally conductive layer.

3. The light emitting diode arrangement according to one of the preceding claims,
in which the thermally conductive layer (21) occupies at least 60 % of an area of the common plane of the circuit board (10).

4. The light emitting diode arrangement according to one of the preceding claims,
wherein the high-power light emitting diode (34) has a power consumption of at least 300 mW.

5. The light emitting diode arrangement according to one of the preceding claims,
in which the high-power light emitting diode (34) has a thermal connecting part (36) which is in thermal contact with the thermally conductive layer (21).

6. The light emitting diode arrangement according to one of the preceding claims,
in which the high-power light emitting diode (34) is soldered onto the flexible circuit board (10).

7. The light emitting diode arrangement according to claim 5,
in which the flexible circuit board (10) is a mounting support and in which the heat produced during operation of the high-power light emitting diode is dissipated to the mounting support.

8. The light emitting diode arrangement according to one of the preceding claims,
in which the flexible carrier layer (33) comprises at least one of the following materials: polyimide, polyethylene naphthalate, polyester, FR4.

9. The light emitting diode arrangement according to one of the preceding claims,
in which the thermally conductive layer (21) contains a metal.

10. The light emitting diode arrangement according to one of the preceding claims,
in which the thermally conductive layer (21) contains copper.

11. The light emitting diode arrangement according to one of the preceding claims,
in which the high-power light emitting diode (34) is soldered onto the thermally conductive layer (21).

12. The light emitting diode arrangement according to one of the preceding claims,
in which the thermally conductive layer (21) and the electrical conductor tracks (22), (23) contain the same metal.

13. The light emitting diode arrangement of one of the preceding claims,
in which an insulating layer (12) is applied to one of the surfaces of the flexible circuit board (10).

14. The light emitting diode arrangement according to the preceding claim,
in which the insulating layer (12) has recesses for the electrical and thermal contacting of the high-power light emitting diode (34).

15. The light emitting diode arrangement according to claims 13 and 14,
in which the insulating layer (12) contains a solder resist.

16. A light emitting diode arrangement according to one of the preceding claims, in which the side of the flexible circuit board (10) remote from the high-power light emitting diodes (34) has an adhesive-containing layer (32).

17. The light emitting diode arrangement according to the preceding claim,
in which the adhesive-containing layer (32) is formed by a double-sided adhesive tape.

18. The light emitting diode arrangement according to any of claims 16 to 17,
wherein the adhesive-containing layer (32) is heat resistant up to 250 °C.

19. The light emitting diode arrangement according to 16 to 18,
in which the adhesive-containing layer (32) has a maximum thickness of 60 µm.

20. The light emitting diode arrangement according to claims 16 to 19,
in which the adhesive-containing layer (32) is covered with a protective film (31).

21. The light emitting diode arrangement according to the preceding claim,
in which the protective film (31) contains a plastic.

22. The light emitting diode arrangement according to one of the preceding claims,
wherein a plurality of high-power light emitting diodes (34) are provided which are connected in series.

23. The light emitting diode arrangement according to claim 22,
in which a pair of contact surfaces (15) is provided for each high-power light emitting diode (34).

24. The light emitting diode arrangement according to the preceding claim,
which is divided into sections (11), wherein the sections each comprise a high-power light emitting diode (34) and a pair of contact surfaces (15) associated with the high-power light emitting diode.

25. The light emitting diode arrangement according to any of the preceding claims 22 to 24,
in which the high-power light emitting diodes (34) are each in thermal contact with a thermally conductive layer (21), and the light emitting diode arrangement can be divided in such a way that individual sections (11) are formed, each having a high-power light emitting diode (34), a thermally conductive layer (21) and the pair of contact surfaces (15).

26. The light emitting diode arrangement according to any of claims 24 to 25,
in which the sections (11) are arranged as repeating structures.

27. The light emitting diode arrangement according to the preceding claim,
in which the sections (11) are arranged in a row.

28. A lighting device,
comprising a light emitting diode arrangement according to one of the preceding claims, wherein a heat sink provided, onto which the light emitting diode arrangement is applied.

29. The lighting device according to the preceding claim, wherein the light emitting diode arrangement is glued to the heat sink.

30. The lighting device according to any of claims 28 to 29, wherein the heat sink contains a metal.

31. The lighting device according to any of claims 28 to 30, wherein the heat sink is part of a lamp housing.

32. The lighting device according to the previous claim, wherein the lamp housing is the housing for one of the following lamps: automobile interior illumination, automobile rear illumination, brake light, flashing indicator.

33. A method of manufacturing a light emitting diode arrangement according to claim 1,
wherein an adhesive-containing layer (32) is fixed to the flexible carrier layer (33), the thermally conductive layer (21) and the electrical conductor tracks (22, 23) are applied to a side of the flexible carrier layer (33) remote from the adhesive-containing layer (32), a plurality of high-power light emitting diodes (34) are soldered on the electrical conductor tracks (22, 23), and the adhesive-containing layer is applied before the high-power light emitting diodes are soldered.

## Revendications

1. Réseau de diodes électroluminescentes comprenant au moins une diode électroluminescente haute puissance (34) et un circuit imprimé flexible (10) doté de pistes conductrices électriques (22, 23), la diode électroluminescente haute puissance (34) étant montée sur le circuit imprimé flexible (10),
- le circuit imprimé flexible (10) comprenant une couche thermo-conductrice (21) en contact thermique avec la diode électroluminescente haute puissance (34), et
- la couche thermo-conductrice (21) et les pistes conductrices électriques (22, 23) étant situées à un niveau commun du circuit imprimé flexible (10), le circuit imprimé flexible (10) contient une couche de support flexible (33), dans lequel les pistes conductrices électriques (22, 23) sont placées sur la couche de support flexible (33),
**caractérisé en ce que**
la couche thermo-conductrice (21) est placée sur la couche de support flexible et la couche thermo-conductrice (21) n'étant pas en contact électrique avec les pistes conductrices électriques (22, 23).

2. Réseau de diodes électroluminescentes selon la revendication 1,
dans lequel la couche thermo-conductrice (21) et les pistes conductrices électriques (22, 23) ne sont pas reliées les unes aux autres sur le niveau commun du circuit imprimé flexible (10) et la diode électroluminescente haute puissance (34) est soudée sur la couche thermo-conductrice.

3. Réseau de diodes électroluminescentes selon l'une des revendications précédentes,
dans lequel la couche thermo-conductrice (21) occupe au moins 60 % d'une surface du niveau commun du circuit imprimé (10).

4. Réseau de diodes électroluminescentes selon l'une des revendications précédentes,
dans lequel la diode électroluminescente haute puissance (34) présente une puissance absorbée d'au moins 300 mW.

5. Réseau de diodes électroluminescentes selon l'une des revendications précédentes, dans lequel la diode électroluminescente haute puissance (34) a un connecteur thermique (36) en contact thermique avec la couche thermo-conductrice (21).

6. Réseau de diodes électroluminescentes selon l'une des revendications précédentes,
dans lequel la diode électroluminescente haute puissance (34) est soudée sur le circuit imprimé flexible (10).

7. Réseau de diodes électroluminescentes selon la revendication 5,
dans lequel le circuit imprimé flexible (10) est un support de montage et dans lequel la chaleur produite pendant le fonctionnement de la diode électroluminescente haute puissance est transmise au support de montage.

8. Réseau de diodes électroluminescentes selon l'une des revendications précédentes,
dans lequel la couche de support flexible (33) comprend au moins l'un des matériaux suivants : polyimide, polyéthylènaphtalate, polyester, FR4.

9. Réseau de diodes électroluminescentes selon l'une des revendications précédentes,
dans lequel la couche thermo-conductrice (21) contient un métal.

10. Réseau de diodes électroluminescentes selon l'une des revendications précédentes,
dans lequel la couche thermo-conductrice (21) comprend du cuivre.

11. Réseau de diodes électroluminescentes selon l'une des revendications précédentes,
dans lequel la diode électroluminescente haute puissance (34) est soudée sur la couche thermo-conductrice (21).

12. Réseau de diodes électroluminescentes selon l'une des revendications précédentes,
dans lequel la couche thermo-conductrice (21) et les pistes conductrices électriques (22), 23) contiennent le même métal.

13. Réseau de diodes électroluminescentes l'une des revendications précédentes,
dans lequel une couche isolante (12) est appliquée sur l'une des surfaces du circuit imprimé flexible (10).

14. Réseau de diodes électroluminescentes selon la revendication précédente,
dans lequel la couche isolante (12) présente des évidements pour le contact électrique et thermique de la diode électroluminescente haute puissance (34).

15. Réseau de diodes électroluminescentes selon les revendications 13 et 14,
dans lequel la couche isolante (12) contient un vernis de soudure.

16. Réseau de diodes électroluminescentes selon l'une des revendications précédentes, dans lequel le côté du circuit imprimé flexible (10) opposé aux diodes électroluminescentes haute puissance (34) présente une couche contenant de l'adhésif (32).

17. Réseau de diodes électroluminescentes selon la revendication précédente,
dans lequel la couche contenant de l'adhésif (32) est formée par un ruban adhésif double face.

18. Réseau de diodes électroluminescentes selon l'une des revendications 16 à 17,
dans lequel la couche contenant de l'adhésif (32) résiste à des températures pouvant atteindre 250 °C.

19. Réseau de diodes électroluminescentes selon les revendications 16 à 18,
dans lequel la couche contenant de l'adhésif (32) a une épaisseur maximale de 60 µm.

20. Réseau de diodes électroluminescentes selon les exigences 16 à 19,
dans lequel la couche contenant de l'adhésif (32) est recouverte d'un film protecteur (31).

21. Réseau de diodes électroluminescentes selon l'une des revendications précédentes,
dans lequel le film protecteur (31) contient une matière plastique.

22. Réseau de diodes électroluminescentes selon l'une des revendications précédentes,
dans lequel une pluralité de diodes électroluminescentes haute puissance (34) connectées en série sont prévues.

23. Réseau de diodes électroluminescentes selon la revendication 22,
dans lequel une paire de surfaces de contact (15) est prévue pour chaque diode électroluminescente haute puissance (34).

24. Réseau de diodes électroluminescentes selon la revendication précédente,
divisé en sections (11), les sections comprenant chacune une diode électroluminescente haute puissance (34) et une paire de surfaces de contact (15) associée à ladite diode électroluminescente haute puissance.

25. Réseau de diodes électroluminescentes selon l'une des revendications 22 à 24,
dans lequel les diodes électroluminescentes haute puissance (34) sont chacune en contact thermique avec une couche thermo-conductrice (21) et le réseau de diodes électroluminescentes peut être divisé de telle manière que des sections individuelles (11) sont formées, chacune disposant d'une diode électroluminescente haute puissance (34), d'une couche thermo-conductrice (21) et de la paire de surfaces de contact (15).

26. Réseau de diodes électroluminescentes selon l'une des exigences 24 à 25,
dans lequel les sections (11) sont disposées en structures récurrentes.

27. Réseau de diodes électroluminescentes selon la revendication précédente,
dans lequel les sections (11) sont disposées en ligne.

28. Dispositif d'éclairage,
comprenant un réseau de diodes électroluminescentes selon l'une des revendications précédentes, un dissipateur thermique sur lequel repose le réseau de diodes électroluminescentes étant prescrit.

29. Dispositif d'éclairage selon la revendication précédente,
dans lequel le réseau de diodes électroluminescentes est collé sur le dissipateur thermique.

30. Dispositif d'éclairage selon l'une des revendications 28 à 29,
dans lequel le dissipateur thermique contient un métal.

31. Dispositif d'éclairage selon l'une des revendications 28 à 30,
dans lequel le dissipateur thermique fait partie d'un boîtier de lampe.

32. Dispositif d'éclairage selon la revendication précédente,
dans lequel le boîtier de lampe est le boîtier de l'une des lampes suivantes : éclairage intérieur de voiture, feux arrière de voiture, feu de freinage, clignotant.

33. Procédé de fabrication d'un réseau de diodes électroluminescentes selon la revendication 1,
dans lequel une couche contenant de l'adhésif (32) est fixée sur la couche de support flexible (33), la couche thermo-conductrice (21) et les pistes conductrices électriques (22, 23) sont appliquées sur un côté de la couche de support flexible (33) opposé à la couche contenant de l'adhésif (32), une pluralité de diodes électroluminescentes haute puissance (34) sont soudées sur les pistes conductrices électriques (22, 23), et
la couche contenant de l'adhésif est appliquée avant le soudage des diodes électroluminescentes haute puissance.
